(19) **Europäisches Patentamt / European Patent Office / Office européen des brevets**

(11) **EP 1 388 932 B1**

(12) **EUROPEAN PATENT SPECIFICATION**

(45) Date of publication and mention
of the grant of the patent:
**06.08.2008 Bulletin 2008/32**

(51) Int Cl.:
***H03C 1/36*** (2006.01)

(21) Application number: **03077310.5**

(22) Date of filing: **22.07.2003**

(54) **Switching modulator**

Geschalteter Modulator

Modulateur commutaté

(84) Designated Contracting States:
**DE ES FR GB NL**

(30) Priority: **22.07.2002 NL 1021125**

(43) Date of publication of application:
**11.02.2004 Bulletin 2004/07**

(73) Proprietor: **N.V. Nederlandsche Apparatenfabriek NEDAP**
**7141 DC Groenlo (NL)**

(72) Inventor: **Fockens, Tallienco Wieand Harm**
**7165 BR Rietmolen (NL)**

(74) Representative: **Prins, Adrianus Willem et al**
**Vereenigde**
**P.O.Box 87930**
**2508 DH Den Haag (NL)**

(56) References cited:
**EP-A- 0 917 088      EP-A- 1 202 216**
**US-A- 5 418 353      US-A- 5 804 811**
**US-A- 6 161 762      US-B1- 6 304 613**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

<u>Background of the invention</u>

In an RFID system (Radio Frequency IDentification), identification labels are read out by a reader unit, also referred to as interrogator or reader. There is a large variety of applications for these systems, such as access control, animal identification and livestock management systems, identification of goods, industrial automation, etc.

Traditionally, a reader unit consists of a transmitter circuit which generates a high-frequency signal of some power and with which, by means of an antenna coil, a magnetic field is generated. This magnetic field in turn induces a voltage in a coil of a label present in the field. With that voltage, an electronic circuit is supplied that generates a code representing the number that is stored in the memory of the circuit.

One or more properties of the resonance circuit of which the above-mentioned coil is a part, is modulated with the code signal. With that, the secondary magnetic field of the coil is also modulated, and this signal is received back in the antenna coil of the reader unit. A receiver circuit, also connected with the antenna coil, selects this label signal out, amplifies and decodes it, thereby reading out the number stored in the label.

In the oldest RFID systems, the number was unchangeably stored during the production of the label. In later systems, it became possible to modify this number, or to store entirely different data in the label. This makes it necessary for the signal transmitted by the reader unit not only to have as a task to provide the label with energy, but also to work as carrier wave for transporting data from the reader unit to the label. In view of the requirement to limit the complexity of the circuit in the label, amplitude modulation (AM, ASK, OOK) is a preferred modulation form.

In the newest RFID systems, the signal transmitted by the reader unit has been given a further, third function, viz. that of control signal for the purpose of the communication protocol. This involves the so-called Reader Talk First systems. In the previous systems (Tag Talk First), a label starts to transmit its code signal as soon as sufficient energy is being drawn from the magnetic field. As a consequence of this, in the case where several labels are located in the field simultaneously, these labels (may) start to transmit simultaneously as well, so that the reception in the receiver of the reader unit is disturbed. In many applications, however, it is necessary that a large number of labels may be located in the interrogation field simultaneously. This problem is solved by means of an anti-collision protocol in combination with the Reader Talk First principle. A label does not start to transmit its data signal until the reader unit has given a command to that effect. If several labels are located in the field, these labels are allocated to time slots, temporarily switched off, or otherwise controlled in accordance with the respective protocol. There are many different anti-collision protocols known.

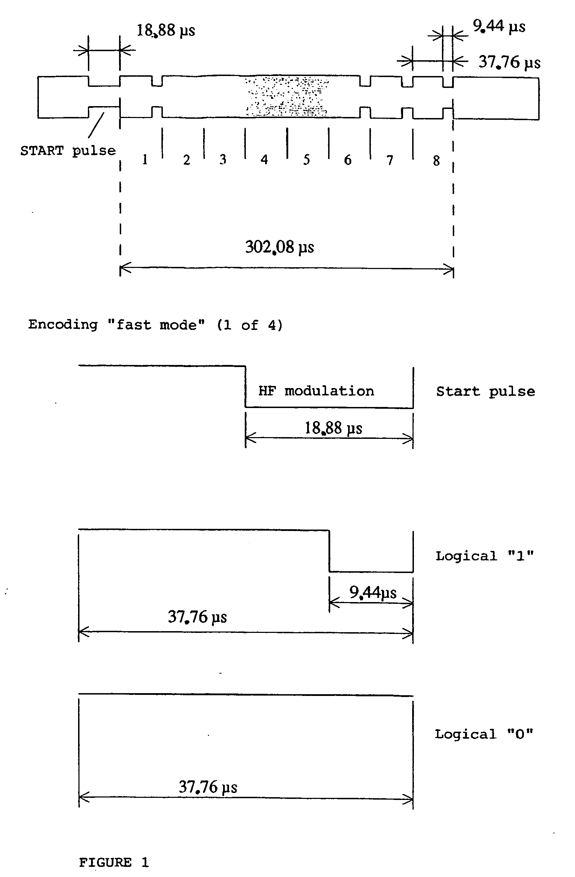

Mentioned by way of example here are the systems that meet the standard for vicinity person cards according to ISO 15693. The carrier frequency of the interrogation signal is 13.56 MHz. The interrogation signal is modulated by briefly interrupting the carrier (100% modulation) or inducing a dip in the amplitude (modulation depth about 20%). The duration of these interruptions or dips is 9.5 or 19 $\mu$s. The data is encoded in the position of the modulations. Fig. 1 illustrates this process.

Amplitude modulation is generated, for instance, by varying the supply voltage of one or more amplifier stages. For an optimum power efficiency, this can be carried out best on the last amplifier stage, which delivers the transmission energy to the antenna (output stage).

In these RFID systems, the interrogator continuously transmits a carrier, which carrier generates the supply voltage in the label. By means of amplitude modulation of this carrier, data is sent to the label, and subsequently the label is triggered to transmit a return signal. In the earlier-mentioned standard, it can be found that the data communication from the label to the reader unit proceeds by means of modulation of a subcarrier. This subcarrier in turn modulates the resonance circuit in the label. The subcarrier frequencies in the case of ISO standard 15693 are 424 and 484 kHz. These subcarriers give rise to sidebands at the frequencies 13.56 MHz $\pm$ 424 kHz and 13.56 MHz $\pm$ 484 kHz.

The receiver section of the reader unit thus receives in either of the two pass bands, 13.56 MHz $\pm$ (400 - 500) kHz, or both.

If this interrogation signal is contaminated with noise which has been modulated on the interrogation signal and manifests itself as noise sidebands, this noise is also received in the receiver. As a consequence, the label signals to be received may be masked by this transmitter noise.

It is to be noted here that the modulation sidebands, which arise upon amplitude modulation of the interrogation signal, cannot mask the label signals to be received, because the labels do not transmit that return signal until the modulation of the interrogation signal has stopped.

It is therefore of great importance to keep the transmitted (interrogation) signal free of noise components.

If noise is superposed on the supply voltages of the transmitter amplifier stages which normally occurs - this noise is modulated on the interrogation signal. The modulation can involve both amplitude modulation, phase modulation, or a combination of the two possibilities. This noise is then constantly present, also in the receiving periods.

To prevent this parasitic modulation of noise, these supply voltages need to be filtered properly, *inter alia* by means of parallel capacitors having high capacitance values. This requirement, however, is in conflict with the requirement of being able to vary the supply voltage fast for amplitude modulation of the interrogation signal.

US patent No. 5,418,353 discloses a radiofrequency identification-interrogation unit according to the preamble of claim 1.

Summary of the invention

The object of the invention is to provide a solution to the above-indicated problem, which is defined in claim 1.

Brief description of the drawings

These and other objects and advantageous aspects of the invention will be described on the basis of an embodiment, with reference to the following drawings.

Figure 1 illustrates a modulation process according to the prior art;
Figure 2 shows a modulation circuit;
Figures 3 and 4 show graphs of signal forms;
Figures 5, 6-9 show amplitude modulation forms;
Figures 10 and 11 show modulation circuits.

Detailed description

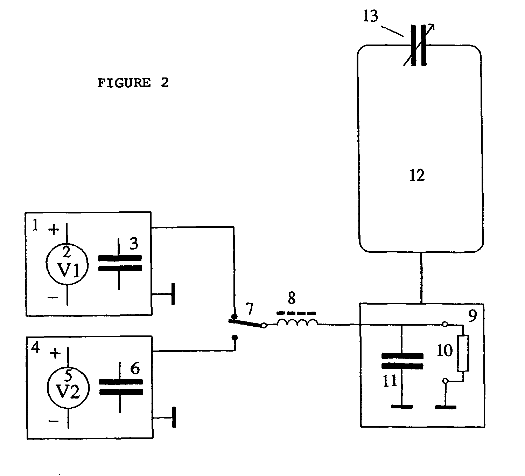

Figure 2 shows a circuit according to the invention with two supply voltage sources 1, 4. Implementations of supply voltage sources 1, 4 are known per se and therefore the most important parts are indicated only symbolically. A first supply voltage source 1 comprises a voltage source 2 with supply voltage V1 and filter capacitor 3. A second supply voltage source 4 comprises a voltage source 5 with supply voltage V2, and a filter capacitor 6. The voltages formed by voltage sources 2, 5 are coupled to the outputs of supply voltage sources 1, 4. Filter capacitors 3, 6 are included in a circuit (not shown) to filter out fluctuations in the supply voltage; to that end, they may, for instance, be coupled parallel to voltage sources 2, 5. For each circuit, it holds that the higher the capacitance value of filter capacitors 3, 6, the more fluctuations are filtered out. The voltage sources are indicated very schematically, since there is a large variety of detail circuits, which details are not relevant here.

The output voltages of the two supply voltage sources 1 and 4 are passed to switch 7. Switch 7 is switched in the rhythm of the modulation of the interrogation signal.

Coil 8 connects switch 7 with the transmitter circuit 9. Transmitter circuit 9 comprises an output amplifier for a radiofrequency signal, by means of which an antenna loop 12 is driven. Implementations of transmitter circuits are known per se, and therefore elements from the transmitter circuit are designated symbolically. Resistance 10 indicates the load which the transmitter circuit forms for the supply voltage. Capacitor 11 represents one or more decoupling capacitors, which serve to close the high-frequency signal paths within transmitter amplifier circuits, and to prevent high-frequency signal components from the transmitter circuit from flowing back to the modulator and supply circuits.

The transmitter circuit 9 drives the antenna loop 12. This antenna loop has been tuned with the aid of tuning capacitor 13 to the carrier frequency of the interrogation signal, and constitutes a narrow-band resonant circuit.

If coil 8 is not present and is replaced with a through-connection, capacitor 11 will be parallel either to capacitor 3 in supply voltage source 1, or to capacitor 6 in supply voltage source 4. Since the voltages V1 and V2 are different, the voltage across capacitor 11 will, upon switching of the switch 7, also change in one step. This may be accompanied by a high current peak in the connection between the capacitors 3 or 6 on the one hand and capacitor 11 on the other. The high current peak will give rise to power dissipation in the loss resistances of switch 7. In addition, the steep voltage step of the supply voltage of the transmitter amplifier 9 will give rise to unduly broad modulation sidebands of the interrogation signal, and hence to electromagnetic interference (EMI).

The task of coil 8 is therefore to limit the current peaks and to provide for a gradual variation of the modulated supply voltage of the transmitter circuit. Coil 8 forms, together with capacity 11 and parallel impedance 10, a resonating low pass filter. The resonant frequency is given by $f = 1 / 2\pi\sqrt{LC}$, , while the damping factor D is given by $D = \sqrt{L/C} / R$. R equals the load resistance 10.

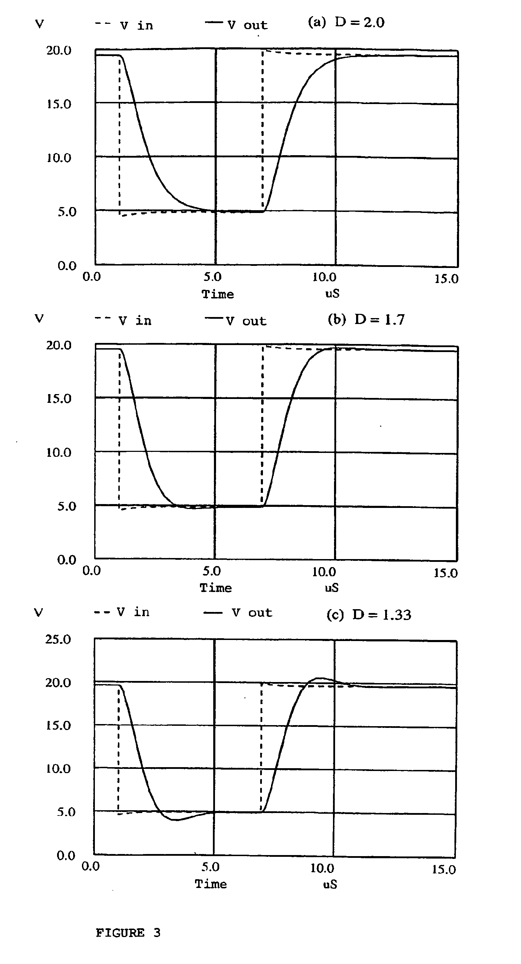

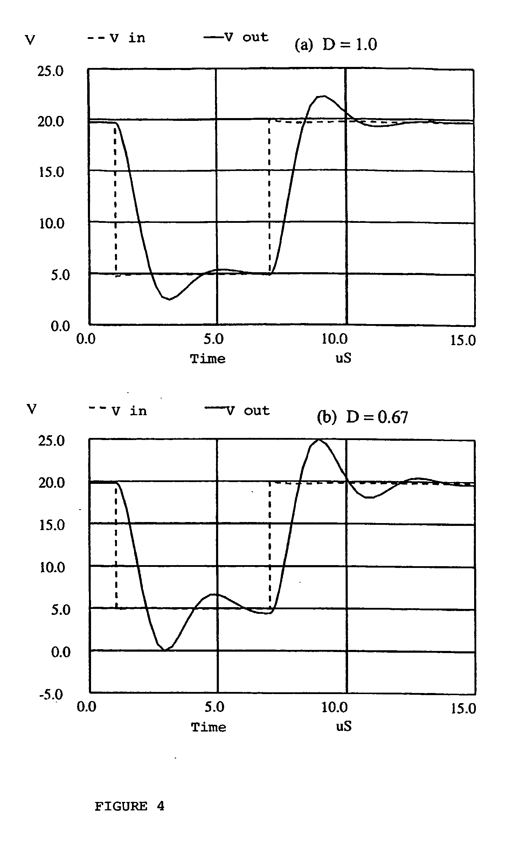

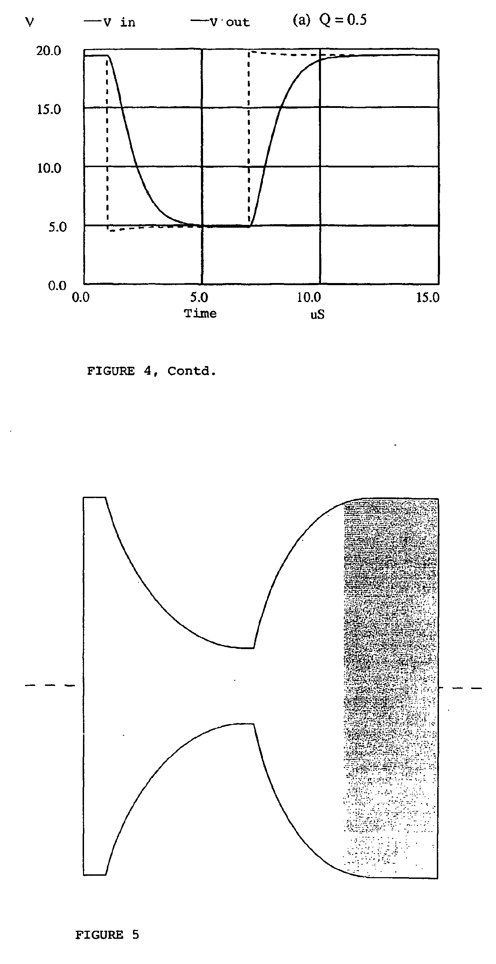

The effect of the magnitude of the damping factor on the signal form is visualized in Figs. 3 and 4.

These figures shows the results of SPICE simulations of the present circuit of Fig. 2. $V_{in}$ is the voltage on the node between switch 7 and coil 8. And $V_{out}$ is the supply voltage of the transmitter across capacitor 11. In these figures, it can be properly seen how, and at what rate, the supply voltage approaches the final value after a step, either from the same direction from which the curve starts (undershoot, D = 2.0 and D = 1.7) or a curve which first shoots beyond the final value and then, by way of one or more oscillations, reaches the final value (overshoot, D = 1.33, D = 1.0, and D = 0.67). Further, it is clear that according as the damping factor is smaller, the time required for getting for the first time into the vicinity of the final value is less.

With the output signal, the transmitter drives an antenna, consisting of a tuned loop 12 which, because of the current in the loop, generates a magnetic field. To be able to generate with a limited signal power a strongest possible magnetic field, the circuit current in the loop must also be as large as possible. This is achieved by giving the tuned antenna loop a highest possible Q factor, for instance of a magnitude of Q = 50. Such a high Q factor for the antenna loop implies a small bandwidth, and hence a long rise time if the amplitude of the transmitted signal is switched from one level to the other.

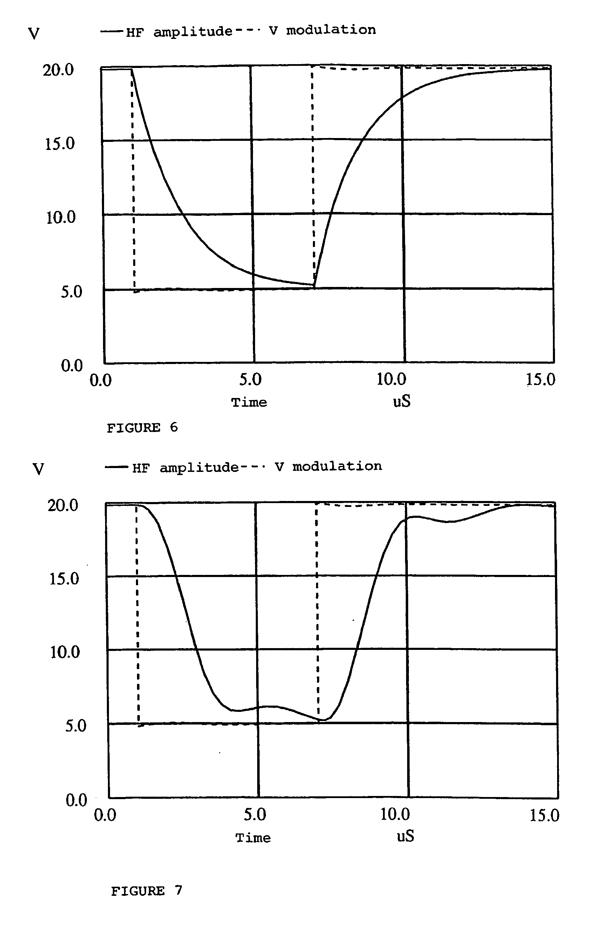

Figs. 5 and 6 show the resultant form of the amplitude modulation if the tuned antenna loop is driven with a rectangular modulated transmitted signal.

In Fig. 7, the transmitted signal is modulated in a manner according to the invention. It is clear to see that the resultant amplitude modulation has a more rectangular shape, while the inclined flanks and the rounded parts provide for a limited RF bandwidth. In this simulation, the Q factor of the antenna loop is 27, the damping factor of the modulator circuit is 0.67, the self-induction of coil 8 is 10 μH, the capacitance of capacitance 11 is 33 nF.

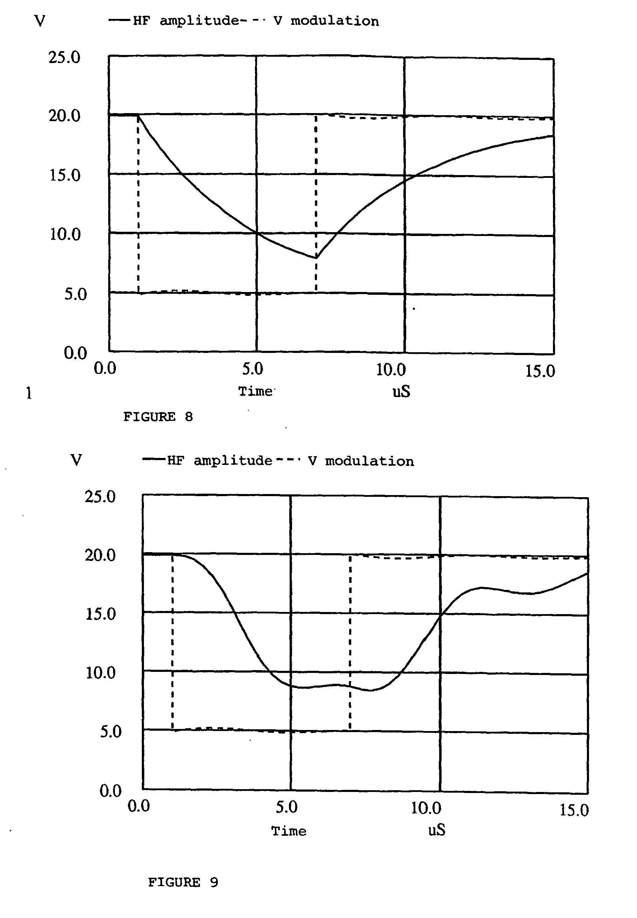

Figs. 8 and 9 show the same as Figs. 6 and 7, respectively, but now for a Q factor of the antenna loop of 50, a damping factor of the modulator circuit of 0.32, and a capacitance of capacitance 11 of 60 nF. These examples show that the manner of modulation according to the invention has a positive side-effect, viz. the possibility of compensating the inertia of a narrowband antenna loop by means of the subcritically damped low pass filter in the modulator circuit.

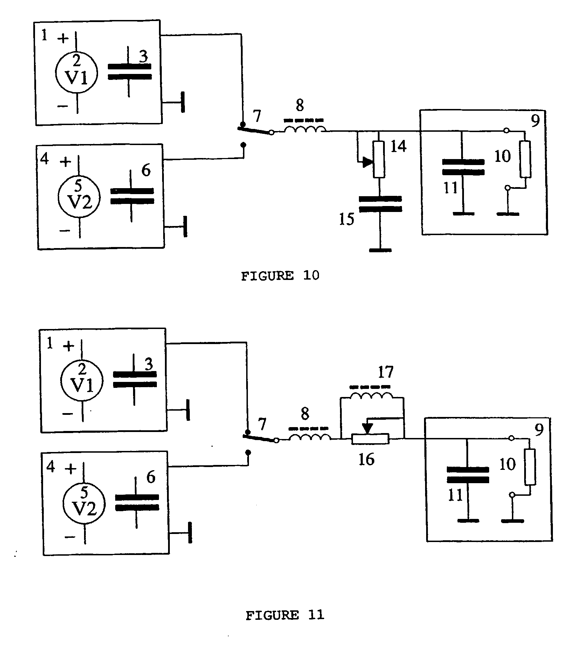

Accordingly, it may be of interest to make the damping of the low pass filter settable, so that the compensation is such that the resulting modulation is optimal. In the circuit of Fig. 2, damping is determined by the DC load resistance 9, which represents the load by the transmitter amplifier. This resistance cannot be made settable. However, by connecting a settable resistance 14 in parallel, this *can* be realized, see Fig. 10. To prevent this damping resistance from forming a short-circuit for the direct current, capacitor 15 has been connected in series. The capacity of capacitor 15 is much greater than that of capacity 11.

The circuit of Fig. 10 functions satisfactorily for a modulation depth up to 20%. With greater modulation depths, the great capacity of capacitor 13 may cause deformation of the modulation pulses. A solution to that problem is to arrange the extra damping in the form of a series resistance 16, as represented in Fig. 11. To prevent direct current losses in series resistance 16, it can be bridged with coil 17, in which case the self-induction of coil 17 must be much greater than that of coil 8.

Summarizing, there is provided a radiofrequency identification interrogation unit in which the interrogation signal is amplitude modulated by switching, with the aid of an electronic switch, the supply for the output amplifier in the transmitter circuit between two well-filtered voltage sources, whose voltage values have been pre-set. According to the invention, in the connection between the electronic switch and the output amplifier, a coil is included having such a self-induction that this coil, together with *inter alia* parallel capacitors present in the output amplifier, forms a low pass filter. Further, parallel to the output amplifier, or in series with it, a settable resistance can be connected, such that the damping factor of the low pass filter can be set such that in combination with the Q factor of the resonating antenna loop the radiofrequency current through the antenna loop is modulated in an optimum form.

**Claims**

1. A radiofrequency identification-interrogation unit for transmitting a radiofrequency signal to an identification label, which identification-interrogation unit is provided with

   - a first and a second voltage source (1, 4), each having an output,
   - a transmitter circuit (9) which comprises an output amplifier and a supply input which is coupled to the output amplifier, and
   - an electronic switch (7) coupled between the supply input and the outputs of the voltage sources (1, 4), and arranged to couple the supply input during modulation alternately to the output of the first and second voltage source (1, 4),

   **characterized in that**

   - the first and a second voltage source (1, 4) are low pass filtering voltage sources, having each an output delivering its own, pre-set voltage, and wherein the output amplifier comprises at least one parallel capacitor (11) coupled in parallel with the voltage source (1, 4) supplying its voltage to the transmitter circuit (9) and wherein the identification-interrogation unit is provided with a coil (8) coupled between the electronic switch (7) and the supply input, and wherein the coil (8), together with the at least said one parallel capacitor (11), forms a low pass filter.

2. A radiofrequency identification-interrogation unit according to claim 1, and provided with a resonating antenna loop (12) for transmitting the radiofrequency signal, which identification-interrogation unit is provided with a settable resistance (14) parallel to the output amplifier, with a setting range such that a damping factor of the low pass filter can be set such that, in combination with the Q factor of the resonating antenna loop (12), the radiofrequency current through the antenna loop (12) is modulated in an optimum ratio between rise time and the width of the modulation sidebands.

3. A radiofrequency identification-interrogation unit according to claim 2, wherein the low pass filter is damped subcritically, so that the subcritical damping compensates an inertia of the antenna loop (12).

4. A radiofrequency identification-interrogation unit according to claim 2, and provided with a resonating antenna loop (12) for transmitting the radiofrequency signal, which identification-interrogation unit is provided with a settable resistance (16) in series with the coil (8) to the output amplifier, with a setting range such that the damping factor of the low pass filter can be set such that in combination with the Q factor of the resonating antenna loop (12) the radiofrequency current through the antenna loop (12) is modulated in an optimum ratio between rise time and the width of the modulation sidebands.

5. A radiofrequency identification-interrogation unit according to claim 4, wherein the low pass filter is damped subcritically, so that the subcritical damping compensates an inertia of the antenna loop (12).

**Patentansprüche**

1. Funkfrequenzidentifizierungs- und Abfrageeinheit zum Übertragen eines Funkfrequenzsignals an eine Identifizierungsmarke, wobei die Identifizierungs- und Abfrageeinheit versehen ist mit

- einer ersten und einer zweiten Spannungsquelle (1, 4), die jeweils einen Ausgang aufweisen,
- einer Transmitterschaltung (9), die einen Ausgangsverstärker und einen mit dem Ausgangsverstärker verbundenen Versorgungseingang, und
- einem elektronischen Schalter (7), der zwischen den Versorgungseingang und die Ausgänge der Spannungsquellen (1, 4) gekoppelt und derart angeordnet ist, dass er den Versorgungseingang während der Modulation abwechselnd mit dem Ausgang der ersten und der zweiten Spannungsquelle (1, 4) verbindet,

**dadurch gekennzeichnet, dass**

- die erste und die zweite Spannungsquelle (1, 4) Tiefpassfilter-Spannungsquellen sind, die jeweils einen Ausgang aufweisen, der eine eigene voreingestellte Spannung liefert, und wobei der Spannungsverstärker mindestens einen Parallelkondensator (11) aufweist, der parallel mit dem Ausgang der Spannungsquelle (1, 4) verbunden ist, welche ihre Spannung an die Transmitterschaltung (9) liefert, und wobei die Identifizierungs- und Abfrageeinheit mit einer Spule (8) versehen ist, welche zwischen den elektronischen Schalter (7) und den Versorgungseingang gekoppelt ist, und wobei die Spule (8) zusammen mit dem mindestens einen Parallelkondensator (11) einen Tiefpassfilter bildet.

2. Funkfrequenzidentifizierungs- und Abfrageeinheit nach Anspruch 1, und versehen mit einer Resonanzantennenschleife (12) zum Übertragen des Funkfrequenzsignals, wobei die Identifizierungs- und Abfrageeinheit mit einem zu dem Ausgangsverstärker parallelen einstellbaren Widerstand (14) versehen ist, dessen Einstellbereich derart ist, dass der Dämpfungsfaktor des Tiefpassfilters derart eingestellt werden kann, dass in Kombination mit dem Q-Faktor der Resonanzantennenschleife (12) der durch die Antennenschleife (12) fließende Funkfrequenzstrom in einem optimalen Verhältnis zwischen Anstiegszeit und der Breite der Modulationsseitenbänder moduliert wird.

3. Funkfrequenzidentifizierungs- und Abfrageeinheit nach Anspruch 2, bei welcher der Tiefpassfilter subkritisch gedämpft ist, so dass subkritische Dämpfung die Trägheit der Antennenschleife (12) kompensiert.

4. Funkfrequenzidentifizierungs- und Abfrageeinheit nach Anspruch 2, und versehen mit einer Resonanzantennenschleife (12) zum Übertragen des Funkfrequenzsignals, wobei die Identifizierungs- und Abfrageeinheit mit einem zu dem Ausgangsverstärker in Reihe geschalteten einstellbaren Widerstand (16) versehen ist, dessen Einstellbereich derart ist, dass der Dämpfungsfaktor des Tiefpassfilters derart eingestellt werden kann, dass in Kombination mit dem Q-Faktor der Resonanzantennenschleife (12) der durch die Antennenschleife (12) fließende Funkfrequenzstrom in einem optimalen Verhältnis zwischen Anstiegszeit und der Breite der Modulationsseitenbänder moduliert wird.

5. Funkfrequenzidentifizierungs- und Abfrageeinheit nach Anspruch 4, bei welcher der Tiefpassfilter subkritisch gedämpft ist, so dass subkritische Dämpfung die Trägheit der Antennenschleife (12) kompensiert.

**Revendications**

1. Dispositif d'identification-interrogation par radiofréquence servant à transmettre un signal radioélectrique à une étiquette d'identification, lequel dispositif d'identification-interrogation comporte

- une première et une seconde sources (1, 4) de tension ayant chacune une sortie,
- un circuit d'émission (9) qui est constitué par un amplificateur de sortie et une entrée d'alimentation couplée à l'amplificateur de sortie, et
- un commutateur électronique (7) monté entre l'entrée d'alimentation et les sorties des sources (1, 4) de tension, et agencé pour coupler l'entrée d'alimentation pendant la modulation en alternance à la sortie de la première et de la seconde sources (1, 4) de tension,

**caractérisé en ce que**

- la première et la seconde sources (1, 4) de tension sont des sources de tension à filtrage passe-bas ayant chacune une sortie délivrant sa propre tension préréglée, et dans lequel l'amplificateur de sortie est constitué par au moins un condensateur parallèle (11) monté en parallèle avec la source (1, 4) de tension fournissant sa tension au circuit d'émission (9), et le dispositif d'identification-interrogation étant pourvu d'une bobine (8) montée entre le commutateur électronique (7) et l'entrée d'alimentation, et la bobine (8), conjointement avec ledit au moins un condensateur parallèle (11), formant un filtre passe-bas.

2. Dispositif d'identification-interrogation par radiofréquence selon la revendication 1, et comportant une antenne cadre accordée (12) pour émettre le signal radioélectrique, lequel dispositif d'identification-interrogation étant pourvu d'une résistance réglable (14), parallèle à l'amplificateur de sortie, avec un domaine de réglage tel qu'un facteur d'amortissement du filtre passe-bande puisse être établi de telle sorte que, en combinaison avec le facteur Q de l'antenne cadre accordée (12), le courant de radiofréquence circulant dans l'antenne cadre (12) soit modulé dans une proportion optimale entre le temps de montée et la largeur des bandes latérales de modulation.

3. Dispositif d'identification-interrogation par radiofréquence selon la revendication 2, dans lequel le filtre passe-bas est amorti de manière subcritique, de telle sorte que l'amortissement subcritique compense une inertie de l'antenne cadre (12).

4. Dispositif d'identification-interrogation par radiofréquence selon la revendication 2, et comprenant une antenne cadre accordée (12) pour transmettre à l'amplificateur de sortie le signal radioélectrique, lequel dispositif étant pourvu d'une résistance réglable (16), en série avec la bobine (8), avec un domaine de réglage tel que le facteur d'amortissement du filtre passe-bas peut être établi de telle sorte que le facteur d'amortissement du filtre passe-bas puisse être établi afin que, en combinaison avec le facteur Q de l'antenne cadre accordée (12), le courant de radiofréquence circulant dans l'antenne cadre (12) soit modulé dans une proportion optimale entre le temps de montée et la largeur des bandes latérales de modulation.

5. Dispositif d'identification-interrogation par radiofréquence selon la revendication 4, dans lequel le filtre passe-bas est amorti de manière subcritique, de telle sorte que l'amortissement subcritique compense une inertie de l'antenne cadre (12).

Encoding "fast mode" (1 of 4)

FIGURE 1

FIGURE 2

V     - - V in    —V out     (a) D = 2.0

20.0

15.0

10.0

5.0

0.0
  0.0          5.0        10.0       15.0
          Time       uS

V     - - V in    —V out     (b) D = 1.7

20.0

15.0

10.0

5.0

0.0
  0.0          5.0        10.0       15.0
          Time       uS

V     - - V in    — V out     (c) D = 1.33

25.0

20.0

15.0

10.0

5.0

0.0
  0.0          5.0        10.0       15.0
          Time       uS

FIGURE 3

FIGURE 4

V    —v in    —v out    (a)  Q = 0.5

FIGURE 4, Contd.

FIGURE 5

FIGURE 6

FIGURE 7

V          ——HF amplitude- - · V modulation

FIGURE 8

V          ——HF amplitude - - · V modulation

FIGURE 9

FIGURE 10

FIGURE 11

**EP 1 388 932 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5418353 A